# EUROPÄISCHE PATENTANMELDUNG

(11) **EP 1 079 435 A1**
(43) Veröffentlichungstag der Anmeldung: **28.02.2001**
(21) Anmeldenummer: 00117997.7
(22) Anmeldetag: 22.08.2000
(51) Int. Cl.: H01L 27/04, H01L 27/20

(54) **Verfahren zur Herstellung integrierter Sensoren**

(30) Priorität: 26.08.1999 DE 19940581
(71) Anmelder: Infineon Technologies AG, 81541 München (DE)
(72) Erfinder: Aigner, Robert, 81675 München (DE); Kapels, Hergen, 85579 Neubiberg (DE); Meckes, Andreas, 81735 München (DE); Oppermann, Klaus-Günter, 83607 Holzkirchen (DE)
(74) Vertreter: Zimmermann & Partner

(57) **Zusammenfassung**

Aussparungen oder Vertiefungen (3) werden in der Oberseite eines Halbleiterkörpers (1) ausgeätzt und Sensorkomponenten (10) darin hergestellt, die etwa zur Hälfte versenkt sind. Elektronische Bauelemente (n,p⁺,5,6,7) werden in dem restlichen Bereich der Oberseite des Halbleiterkörpers (1) hergestellt, wobei diese ggf. mit einer Schutzschicht (7) abgedeckt werden, falls die Aussparung oder Vertiefung erst nachträglich hergestellt wird.

## Beschreibung

Mikromechanische Sensoren basierend auf CMOS-kompatiblen Herstellungstechniken bedürfen aufgrund physikalischer und meßtechnischer Grenzen häufig großer vertikal-lateraler Aspektverhältnisse verbunden mit großen Flächen der Sensorelemente. Zur Erzeugung dieser Aspektverhältnisse werden große Schichtdicken von typisch mehr als 1 µm verwendet, die bei einem üblichen Herstellungsprozeß für CMOS-Schaltungen nicht hergestellt werden. Soll ein mikromechanischer Sensor daher mit elektronischen Bauelementen einer Ansteuerschaltung integriert werden, tritt das Problem auf, wie mit den dicken Sensorschichten innerhalb des CMOS-Prozesses verfahren wird. Nach der Strukturierung derartiger Schichten ergeben sich erhebliche Probleme bei nachfolgenden Fototechnikschritten bezüglich ganzflächiger und gleichmäßiger Fotolackbeschichtung. Der Fotolack wird in einem sogenannten Spin-coating-Verfahren aufgebracht, wobei hohe Stufen auf der prozessierten Oberfläche die gleichmäßige Ausbreitung des Fotolacks beim Abschleudern des zunächst nur in der Mitte aufgebrachten Fotolackes verhindern. Dadurch wird es erforderlich, sehr große Mengen an Fotolack zu verbrauchen oder auf hohe Stufen in der Oberflächentopologie zu verzichten.

In S. Middelhoek et al. 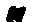 Review Article Silicon Sensors", Meas.Sci. Technol. 6 (1995), 1641 - 1658, gibt einen Überblick über das Gebiet der mikromechanischen Sensoren der letzten 35 Jahre. Beispielsweise wird die Herstellung eines mikromechanischen Sensors auf einem Substrat beschrieben, bei der auf dem Substrat abgeschiedene Opferschichten verwendet werden, die nach Erzeugung des vom Substrat abstehenden Teils des mikromechanischen Sensors wieder entfernt werden. Auch in E. Yoon et al. 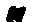 An Integrated Mass Flow Sensor with On-Chip CMOS Interface Circuitry", IEEE, Transactions on Electron Devices, Vol. 39, No. 6, Juni 1992, 1376 - 1385, werden verschiedene Arten von mikromechanischen Sensoren sowie Verfahren zu deren Herstellung beschrieben, darunter ein Drucksensor. Das dabei verwendete Substrat wird beidseitig bearbeitet.

In DE 43 32 057 wird ein Verfahren zur Herstellung eines mikromechanischen Sensors beschrieben, bei dem ein Körper gebildet wird mit einer auf einem Substrat angeordneten isolierenden Schicht und einer darüber angeordneten einkristallinen Siliziumschicht, wobei die Siliziumschicht eine vorgegebene Dotierung aufweist. Es werden Gräben in der Siliziumschicht bis auf die Oberfläche der isolierenden Schicht geätzt. Die Grabenwände werden dotiert. Eine Transistoranordnung wird in einem ersten Bereich der Siliziumschicht erzeugt. Die isolierende Schicht unter einem zweiten Bereich der Siliziumschicht wird entfernt.

In DE 44 14 968 wird ein mikromechanisches Bauteil und ein Verfahren zu dessen Herstellung beschrieben, bei dem im Substrat, auf dem das Bauteil erzeugt wird, eine integrierte Schaltung erzeugt wird. Die Metallisierung der integrierten Schaltung wird zugleich als Teil des mikromechanischen Bauteils verwendet.

Aufgabe der vorliegenden Erfindung ist es, ein praktikables Verfahren zur Integration von mikromechanischen Sensoren mit hohem Aspektverhältnis mit elektronischen Bauelementen anzugeben. Das Verfahren soll insbesondere geeignet sein, innerhalb eines CMOS-Prozesses ausgeführt zu werden.

Diese Aufgabe wird mit dem Verfahren mit den Merkmalen des Anspruches 1 gelöst. Ausgestaltungen ergeben sich aus den abhängigen Ansprüchen.

Bei dem erfindungsgemäßen Verfahren werden Aussparungen oder Vertiefungen im Substrat, das durch einen Halbleiterkörper gebildet wird, geschaffen, so daß Sensorkomponenten, die darin hergestellt werden, teilweise versenkt sind. Die Aussparungen oder Vertiefungen oder Bereiche, in dem die Oberseite des Halbleiterkörpers gegenüber einem angrenzenden Bereich abgesenkt ist, werden durch Entfernen von Halbleitermaterial aus dem Halbleiterkörper, vorzugsweise durch Ätzen hergestellt, bevor oder nachdem elektronische Bauelemente in dem restlichen Bereich der Oberseite des Halbleiterkörpers hergestellt werden. Falls das Halbleitermaterial erst abgetragen wird, nachdem die elektronischen Bauelemente hergestellt worden sind, werden diese mit einer Schutzschicht abgedeckt. In dem Bereich der Aussparung oder Vertiefung wird eine Schicht abgeschieden, die für die Strukturierung der wesentlichen Bestandteile des Sensorelementes vorgesehen ist und vorzugsweise Polysilizium ist. Diese Schicht überragt die Oberseite des Bauelementes zwischen 20 % und 80 % der Schichtdicke, vorzugsweise zwischen 40 % und 60 % der Schichtdicke, da es für die einfache Herstellbarkeit von Vorteil ist, wenn die Schicht die Oberseite etwa zur Hälfte überragt.

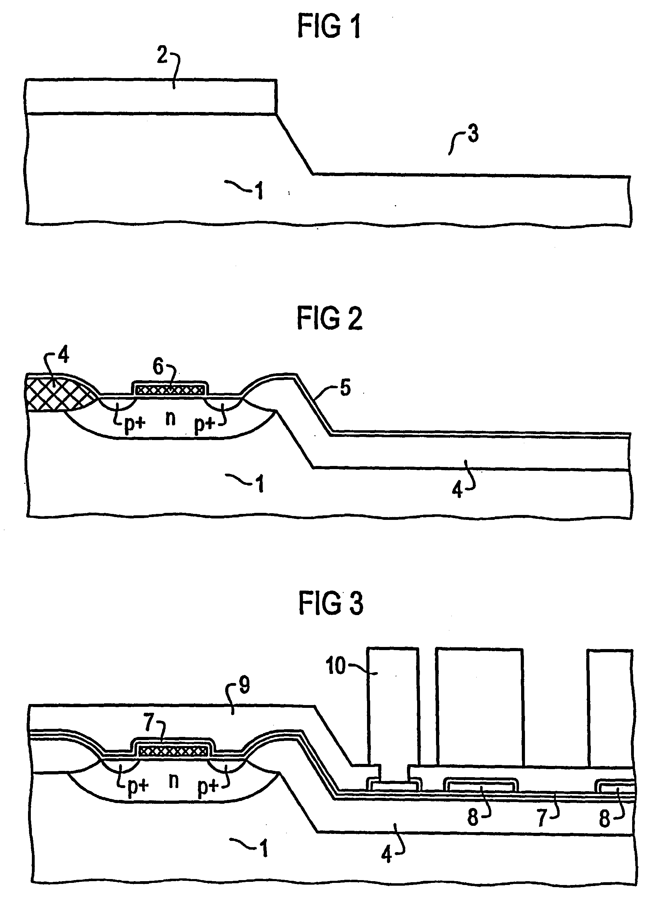

In den Figuren 1 bis 3 sind Querschnitte eines mit dem Verfahren hergestellten Halbleiterchips nach verschiedenen Schritten eines Ausführungsbeispieles dargestellt.

Anhand der Figuren wird das Beispiel beschrieben, bei dem zunächst die Aussparung und dann die Elektronik hergestellt wird. Figur 1 zeigt im Querschnitt ein Substrat, das durch einen Halbleiterkörper 1 gebildet wird. Eine Oberseite des Halbleiterkörpers wird mit einer Maske 2 versehen, so daß während eines nachfolgenden Ätzprozesses das Material unter der Maske stehen bleibt. Seitlich dazu wird die Aussparung 3, Vertiefung oder ein irgendwie gearteter flächiger Bereich, in dem die Oberseite des Halbleiterkörpers im Vergleich zu einem benachbarten Bereich tiefer liegt, ausgebildet. Damit ist die Voraussetzung geschaffen, um ein Sensorelement mit hohem Aspektverhältnis in dem Halbleiterchip zu integrieren, ohne zu hohe Stufen in der Oberfläche zu erzeugen.

Der Ätzprozeß läuft vorzugsweise zeitgesteuert ab, d. h. die Tiefe der Ätzung wird durch die Zeitdauer der Ätzung und den Verlauf des typischen Ätzprofiles bestimmt. Es können sowohl anisotrop, kristallorientierungsabhängig wirkende Ätzmedien als auch isotrop ätzende Ätzmedien, z. B. Ätzlösungen, eingesetzt werden. Vorzugsweise beträgt die Tiefe der Ätzung etwa die Hälfte der Höhe der dort anzubringenden Strukturelemente.

Figur 2 zeigt den Halbleiterkörper 1, in dem nach dem Entfernen der Maske 2 durch Diffusion oder Implantation dotierte Bereiche ausgebildet werden, die in diesem Beispiel eine Wanne n für die Source- und Drainbereiche p⁺ eines Transistors bilden. Die übrigen Bereiche der betreffenden Oberseite des Halbleiterkörpers werden mit einer Isolationsschicht 4 elektrisch isoliert, was bei Verwendung eines Siliziumsubstrates durch lokale thermische Oxidation (LOCOS) geschehen kann. Es wird ganzflächig eine Dielektrikumschicht 5 aufgebracht, die ein Oxid, insbesondere SiO₂, sein kann. Die Dielektrikumschicht dient im Bereich des Kanals des Transistors als Gate-Oxid und wird dort mit einer Gate-Elektrode 6 versehen, die aus einer ersten Polysiliziumabscheidung strukturiert wird.

Figur 3 zeigt den Querschnitt aus Figur 2, nachdem eine Schutzschicht 7, z. B. aus Nitrid, insbesondere Si₃N₄, ganzflächig aufgebracht wurde und in weiteren Abscheideprozessen strukturierte Kontaktbereiche 8, die z. B. aus einer zweiten Polysiliziumabscheidung strukturiert werden, und eine Hilfs- oder Opferschicht 9 hergestellt wurden. Alternativ können die Kontaktbereiche 8 bereits mit der ersten Polysiliziumabscheidung aufgebracht und zusammen mit der oder den Gate-Elektroden 6 strukturiert werden. Die Hilfsschicht dient im Bereich des Transistors auch als zusätzliche Schutzschicht. Auf die Hilfsschicht 9 wird die dicke Schicht 10 aufgebracht, insbesondere als dritte Polysiliziumabscheidung, die für die Strukturierung der Sensorelemente vorgesehen ist. Diese Schicht 10 überragt die Oberseite des Halbleiterkörpers im Bereich des Transistors wie erkennbar nur etwa zur Hälfte. Nach der Strukturierung der Schicht 10 und ggf. weiteren an sich bekannten Verfahrensschritten zur Herstellung von mikromechanischen Sensoren wird die Hilfsschicht 9 zumindest im Bereich des Sensors entfernt, um die Sensorelemente in vorgesehener Weise freizulegen.

Statt des beschriebenen Prozeßablaufs kann ein elektronisches Bauelement zunächst in der noch ebenen Oberseite des Halbleiterkörpers in dem gezeigten oder auch einem davon abweichenden Umfang hergestellt werden. Danach wird der elektronische Teil des Chips abgedeckt, was mit einer Maske, z. B. aus Fotolack, oder einer entsprechend geeigneten örtlich begrenzten Schicht geschehen kann. Diese Abdeckung wird so gewählt, daß eine nachfolgende Ätzung nur Halbleitermaterial in dem für das Sensorelement vorgesehenen Bereich abträgt und die elektronische Komponente unversehrt läßt. Nachdem durch die Ätzung die Aussparung oder Versenkung in dem Halbleiterkörper hergestellt ist, wird dort das Sensorelement in der beschriebenen Weise mit an sich bekannten Verfahrensschritten hergestellt. Zur endgültigen Fertigstellung wird die Abdeckung des elektronischen Teils gegebenenfalls entfernt.

## Patentansprüche

1. Verfahren zur Herstellung integrierter Sensoren, bei dem in einem ersten Schritt an einer Oberseite eines Halbleiterkörpers (1) eine Struktur mindestens eines elektronischen Bauelementes (n, p⁺, 5, 6, 7) hergestellt wird und eine Aussparung (3) oder Vertiefung in dem Halbleiterkörper oder ein Bereich, in dem die Oberseite gegenüber einem angrenzenden Bereich abgesenkt ist, durch Entfernen von Material des Halbleiterkörpers hergestellt wird,
in einem zweiten Schritt in der Aussparung oder Vertiefung oder dem Bereich abgesenkter Oberseite eine Schicht (10) abgeschieden wird, die die Oberseite in vertikaler Richtung überragt,
in einem dritten Schritt die abgeschiedene Schicht für ein mikromechanisches Bauelement strukturiert wird und
in einem vierten Schritt die elektronischen und mikromechanischen Bauelemente einschließlich elektrischer Kontakte und Leiterbahnen fertiggestellt werden.

2. Verfahren nach Anspruch 1,
bei dem in dem ersten Schritt zunächst eine Struktur mindestens eines elektronischen Bauelementes (n, p⁺, 5, 6, 7) hergestellt und mit einer Schutzschicht (7) bedeckt wird und anschließend eine Aussparung (3) oder Vertiefung in dem Halbleiterkörper oder ein Bereich, in dem die Oberseite gegenüber einem angrenzenden Bereich abgesenkt ist, durch Entfernen von Material des Halbleiterkörpers hergestellt wird.

3. Verfahren nach Anspruch 1,
bei dem in dem ersten Schritt zunächst eine Aussparung (3) oder Vertiefung in dem Halbleiterkörper oder ein Bereich, in dem die Oberseite gegenüber einem angrenzenden Bereich abgesenkt ist, durch Entfernen von Material des Halbleiterkörpers hergestellt wird und anschließend eine Struktur mindestens eines elektronischen Bauelementes (n, p⁺, 5, 6, 7) hergestellt wird.

4. Verfahren nach einem der Ansprüche 1 bis 3, bei dem die abgeschiedene Schicht (10) die Oberseite in vertikaler Richtung tun 20% bis 80% ihrer Schichtdicke überragt.

5. Verfahren nach einem der Ansprüche 1 bis 3, bei dem die abgeschiedene Schicht (10) die Oberseite in vertikaler Richtung um 40% bis 60% ihrer Schichtdicke überragt.

6. Verfahren nach einem der Ansprüche 1 bis 5, bei dem die Schicht (10) aus Polysilizium abgeschieden wird.
